# EUROPÄISCHE PATENTSCHRIFT

(11) **EP 3 614 563 B1**
(45) Veröffentlichungstag und Bekanntmachung des Hinweises auf die Patenterteilung: **01.05.2024**
(21) Anmeldenummer: 19188846.0
(22) Anmeldetag: 29.07.2019
(51) Int. Cl.: H03K 17/96

(54) **BERÜHRUNGSSENSITIVE BEDIENVORRICHTUNG MIT HAPTISCHER RÜCKMELDUNG, DIE EINE DRUCKSTÄRKENAUSWERTEEINHEIT AUFWEIST, SOWIE HAUSHALTSGERÄT UND VERFAHREN**
TOUCH-SENSITIVE OPERATING DEVICE WITH HAPTIC FEEDBACK COMPRISING A PRESSURE INTENSITY EVALUATION UNIT AND HOUSEHOLD APPLIANCE AND METHOD
DISPOSITIF DE COMMANDE TACTILE À RÉTROACTION HAPTIQUE COMPORTANT UNE UNITÉ D'ÉVALUATION DE LA RÉSISTANCE À LA PRESSION AINSI QU'APPAREIL ÉLECTROMÉNAGER ET PROCÉDÉ

(30) Priorität: 22.08.2018 DE 102018214142
(43) Veröffentlichungstag der Anmeldung: 26.02.2020
(73) Patentinhaber: BSH Hausgeräte GmbH, 81739 München (DE)
(72) Erfinder: Reindl, Michael, 84175 Schalkham (DE); Steinbacher, Manfred, 83334 Inzell (DE)

(56) Entgegenhaltungen:
- EP-A1- 2 117 122
- US-A1- 2011 037 734
- US-A1- 2017 220 171

## Beschreibung

Ein Aspekt der Erfindung betrifft eine Bedienvorrichtung für Haushaltsgerät. Die Bedienvorrichtung weist ein berührungssensitives Bedienfeld auf, das eine berührbare Bedienplatte und einen Erfassungssensor zum Erfassen einer Berührung der Bedienplatte aufweist. Des Weiteren weist die Bedienvorrichtung einen Körperschallwandler auf, der mit der Bedienplatte gekoppelt ist und welcher zur Abgabe eines akustischen Rückmeldesignals an die Bedienplatte abhängig von einem durch den Erfassungssensor erfolgten Erfassen der Berührplatte ausgebildet ist. Ein weiterer Aspekt betrifft ein Haushaltsgerät, insbesondere zum Zubereiten von Lebensmitteln. Ein nochmals weiterer Aspekt betrifft ein Verfahren zum Betreiben einer Bedienvorrichtung.

Aus der EP 2 117 122 A1 ist allgemein eine Anordnung und ein Verfahren zur haptischen und/oder akustischen Rückmeldung an sensorischen Bedienfeldern bekannt. Die Anordnung weist eine Trägerplatte und einen daran oberflächennah ausgebildeten Sensor auf, der als piezoelektrischer Sensor ausgebildet ist. Dieser Sensor überträgt bei einer Betätigung ein Sensorsignal zu einer Steuereinheit, die eine Auswerteeinheit und eine Signaleinheit aufweist. Das Sensorsignal wird von der Auswerteeinheit in ein Triggersignal für die Signaleinheit umgewandelt. Die Signaleinheit gibt ein Rückmeldesignal ab, das nach der Verstärkung durch einen Verstärker zu einem auf der Rückseite der Trägerplatte angeordneten separaten Schwingungswandler geführt wird. Der Schwingungswandler, der ein Körperschallwandler beziehungsweise ein sogenannter Exciter sein kann, überträgt die Schwingungen über die Trägerplatte zu den Bedienfeldern. Dadurch erfährt ein Bediener taktil und somit haptisch an diesem einen sensorischen Bedienfeld die Rückmeldung.

Bei dieser Ausgestaltung ist die haptische Rückmeldung im Hinblick auf unterschiedliche Betätigungsarten jedoch stark eingeschränkt. Die haptische Rückmeldung kann daher nur eingeschränkt erfolgen.

Aus der US 2017/220171 A1 ist ein Verfahren zum Abschätzen einer Krafteinwirkung auf einen Touchscreen und/oder auf das Gehäuse eines Smartphones bekannt.

Darüber hinaus ist es bekannt, dass Haushaltsgeräte, insbesondere zum Zubereiten von Lebensmitteln, wie Backöfen, über die Bedienvorrichtungen mit berührungssensitiven Displays verfügen. Diese können kapazitiv, resistiv, piezo- oder infrarotsensitiv sein. Im Zusammenhang mit sensorischen Bedienfeldern ist auch eine Vielzahl von Möglichkeiten bekannt, um die Bedienung haptisch und akustisch rückzumelden.

Es ist Aufgabe der vorliegenden Erfindung, eine Bedienvorrichtung für ein Haushaltsgerät sowie ein entsprechendes Verfahren zum Betreiben einer Bedienvorrichtung zu schaffen, bei welchem vielfältige Betätigungsmöglichkeiten gegeben sind und diese individuell haptisch rückgemeldet werden können. Entsprechend ist es auch Aufgabe, ein Haushaltsgerät zu schaffen.

Diese Aufgabe wird durch eine Bedienvorrichtung, ein Haushaltsgerät und ein Verfahren gemäß den unabhängigen Ansprüchen gelöst.

Ein Aspekt der Erfindung betrifft eine Bedienvorrichtung für ein Haushaltsgerät. Die Bedienvorrichtung weist zumindest ein berührungssensitives Bedienfeld auf. Das Bedienfeld weist eine berührbare Bedienplatte und somit eine berührungssensitive Bedienplatte auf. Darüber hinaus weist das Bedienfeld zumindest einen Erfassungssensor zum Erfassen einer entsprechenden Berührung der Bedienplatte in einem berührsensitiven Bereich des Bedienfelds auf. Darüber hinaus weist die Bedienvorrichtung zumindest einen Körperschallwandler auf, der zum Erfassungssensor separat ist und der mit der Bedienplatte gekoppelt ist. Der Körperschallwandler ist zur Abgabe eines akustischen Rückmeldesignals an die Bedienplatte abhängig von einem durch den Erfassungssensor erfassten Berühren der Bedienplatte ausgebildet. Die Bedienvorrichtung weist eine, insbesondere elektronische, Druckstärkenauswerteeinheit auf, mit welcher eine beim Berühren der Bedienplatte, insbesondere im berührungssensitiven Bereich eines Bedienfelds, erzeugte Druckstärke auswertbar ist. Die Druckstärke ist abhängig von einer durch die Druckstärkenauswerteeinheit erfassten Dämpfung eines durch den Körperschallwandler an die Bedienplatte abgegebenen akustischen Referenzsignals bestimmbar. Es ist somit durch die Bedienvorrichtung ermöglicht, dass eine umfänglichere Bedienflexibilität und somit eine umfänglichere Betätigungsflexibilität erreicht ist. Diesen vielfältigeren und variableren Bedienmöglichkeiten, nämlich insbesondere im Hinblick auf ein Erzeugen von unterschiedlichen Drücken auf die berührungssensitive Bedienplatte und damit einhergehend unterschiedlichen individuellen Einstellungen von Betriebsbedingungen, kann somit umfänglicher und individueller auch Rechnung getragen werden, um hierzu jeweils eine individuelle haptische Rückmeldung zu geben. Es wird nun nicht mehr nur die Möglichkeit geschaffen, zwischen einem Berühren und einem Nichtberühren zu unterscheiden, unabhängig davon mit welcher Druckstärke das Berühren erfolgt ist, sondern es kann nunmehr zusätzlich bei einem erfolgten Berühren dann auch noch unterschieden werden, mit welcher Druckstärke dieses Berühren definiert erfolgt ist. Damit lassen sich vielfältigere Einstellungen, die den unterschiedlichen Druckstärken zugeordnet sind, ermöglichen. Allen diesen unterschiedlichen Betätigungen mit unterschiedlichen Druckstärken, die individuellen Betätigungsszenarien der berührungssensitiven Bedienplatte sind, ist nunmehr auch eine individuelle taktile beziehungsweise haptische Rückmeldung zugeordnet beziehungsweise damit verknüpft. Dazu wird gemäß dem genannten Aspekt der Erfindung in besonders vorteilhafter Weise diese individuelle Druckstärke auf Basis einer Dämpfung bestimmt. Es kann somit die eigentlich berührte Komponente und somit die eigentlich mit dem akustischen Referenzsignal beaufschlagte Bedienplatte dann auch dazu als entsprechende Komponente genutzt werden, um eine entsprechende Dämpfung zu bestimmen. Eine sehr komponentenreduzierte und dennoch hochfunktionelle Vorrichtung ist dadurch geschaffen. Diejenige Komponente, nämlich die Bedienplatte, die das Einwirken des akustischen Referenzsignals selbst erfährt, wird dann auch zugrundegelegt, um diese Dämpfung, die durch das individuelle Drücken eines Nutzers auf diese Bedienplatte erzeugt wird, zu bestimmen. Dadurch wird auch ein hocheffizientes, schnelles und sehr genaues Bestimmen der Druckstärke ermöglicht, wodurch auch wiederum eine sehr exakte Erzeugung des akustischen und somit haptisch wahrnehmbaren Rückmeldesignals ermöglicht ist. Insbesondere wird somit ein akustisches Rückmeldesignal individuell abhängig von der festgestellten Dämpfung erzeugt und an die Bedienplatte abgegeben.

Die durch das Drücken auf die Bedienplatte erzeugte Dämpfung dieses Schwingverhaltens der Bedienplatte wird somit dann auch einfach und schnell bestimmt.

Der Körperschallwandler ist insbesondere ein Exciter.

Es ist vorgesehen, dass die Druckstärkenauswerteeinheit zum Vergleichen eines haptisch wahrnehmbaren Schwingsignals der durch das akustische Referenzsignal zum Schwingen angeregten Bedienplatte ohne eine Berührung der Bedienplatte mit einem akustischen, insbesondere durch Berühren spezifisch gedämpften, Ist-Schwingsignal an der Bedienplatte ausgebildet ist und abhängig von dem Vergleich eine Dämpfung bestimmbar ist. Es wird also durch das akustische Referenzsignal, welches von dem Körperschallwandler erzeugt wird und an die Bedienplatte übertragen wird, ein individuelles Schwingverhalten der Bedienplatte beziehungsweise eine akustische Welle durch das Schwingen der Bedienplatte, erzeugt, wobei dieses Schwingverhalten dem dann haptisch wahrnehmbaren akustischen Schwingsignal entspricht. Durch das akustische Referenzsignal wird also ein individuelles akustisches Schwingsignal der Bedienplatte erzeugt, wenn sie noch nicht berührt ist. Dieses haptische wahrnehmbare Schwingsignal der Bedienplatte ist bekannt und insbesondere abgespeichert. Ist nunmehr ein Berühren der Bedienplatte und eine gewisse Druckstärke auf die Bedienplatte erzeugt, so wird dieses Schwingverhalten der Bedienplatte gedämpft und somit auch das akustische Schwingsignal gedämpft. Es entsteht dadurch ein akustisches Ist-Schwingsignal, welches gegenüber dem als Referenz (Schwingung der Bedienplatte ohne Berühren, wenn sie durch das akustische Referenzsignal angeregt wird) abgespeicherten haptisch wahrnehmbaren Schwingsignal gedämpft ist. Insbesondere werden dann diese beiden Signale verglichen und abhängig von einer Abweichung kann dann die Dämpfung sehr exakt bestimmt werden.

Vorzugsweise ist vorgesehen, dass zumindest ein haptisches akustisches Schwingsignal, welches das Schwingen der Bedienplatte ohne Berührung charakterisiert, in einer Speichereinheit der Bedienvorrichtung abgespeichert ist. Insbesondere dann, wenn mehrere Gerätebereiche beziehungsweise berührungssensitive Bedienfelder vorhanden sind, können auch mehrere derartige haptisch wahrnehmbare Signale als Bezugssignale für das jeweilige Schwingungsverhalten der jeweiligen Bedienplatten ohne eine jeweilige Berührung abgespeichert werden, welches Schwingungsverhalten durch das jeweilige akustische Referenzsignal angeregt wird.

Es ist vorgesehen, dass die Druckstärkenauswerteeinheit zumindest einen, zum Körperschallwandler separaten, Sensor zur Erfassung des Ist-Schwingsignals aufweist. Durch diese Ausgestaltung kann sowohl eine lokale unterschiedliche Positionierung zwischen dem Körperschallwandler und diesem zum Erfassen des akustischen Ist-Schwingsignals separaten Sensor erfolgen. Damit kann individuellen Bauraumspezifikationen verbessert Rechnung getragen werden und die jeweilige Funktionalität, einerseits das Aussenden von akustischen Signalen, andererseits das Empfangen von entsprechenden Signalen verbessert erfolgen.

Vorzugsweise ist vorgesehen, dass der Sensor zur Erfassung des akustischen Ist-Signals ebenfalls ein Körperschallwandler ist. Gerade Körperschallwandler können aufgrund ihrer individuellen technischen Ausgestaltung als akustischer Aktuator sowie auch als akustischer Sensor und somit als Sender oder Empfänger genutzt werden. Dies ist insbesondere aufgrund der Ausgestaltung eines derartigen Körperschallwandlers als passives Bauteil mit reziproken Verhalten ermöglicht.

In einer alternativen Ausführung kann vorgesehen sein, dass der Sensor zur Erfassung des Ist-Signals ein Beschleunigungssensor ist. Die Auswertung der Druckstärke durch den Beschleunigungssensor hat im Hinblick auf Bauraumspezifikationen Vorteile. Aufgrund von geringen Abmessungen dieses Beschleunigungssensors können hier vielfältige, platzsparende Verbaupositionen genutzt werden. Bei einer derartigen Ausgestaltung mit einem Beschleunigungssensor erfolgt durch das anregende akustische Referenzsignal ein individuelles Schwingverhalten der Bedienplatte und es resultiert daraus ein individuelles haptisch wahrnehmendes akustisches Schwingsignal der Bedienplatte. Aufgrund dessen erfährt der Beschleunigungssensor, der vorzugsweise mit der Bedienplatte gekoppelt ist, insbesondere direkt daran angeordnet ist, eine individuelle Beschleunigung in spezifischer Raumrichtung. Durch Berühren der Bedienplatte und Ausüben einer gewissen Druckstärke auf die Bedienplatte wird die durch das anregende haptisch wahrnehmbare Schwingsignal erzeugte Beschleunigung gedämpft. Diese Dämpfung der Beschleunigung ist abhängig vom ausgeübten Druck und somit der entsprechenden Druckstärke. Der Beschleunigungssensor ist somit in der Lage, die Beschleunigung in zumindest einer Raumrichtung direkt zu messen. Ein weiterer Vorteil eines Beschleunigungssensors ist dahingehend zu sehen, dass somit eine zusätzliche Messsignalaufbereitung nicht erforderlich ist.

Vorzugsweise, und insbesondere aufgrund der geringen Abmessungen des Beschleunigungssensors, und aufgrund der Kontaktierung des Beschleunigungssensors wird dieser vorzugsweise auf einer Platine montiert. Diese kann eine separate Elektronik sein, die mit der Bedienplatte möglichst mechanisch gekoppelt ist. Zusätzlich oder anstatt dazu kann vorgesehen sein, dass der Beschleunigungssensor direkt an der Bedienplatte angeordnet ist, insbesondere direkt daran anliegend positioniert ist. Beispielsweise kann der Beschleunigungssensor an einer Rückseite beziehungsweise Unterseite der Bedienplatte angeordnet sein, insbesondere angeklebt sein.

Bei der oben genannten Ausführung, bei welcher der Sensor zum Erfassen des Ist-Signals ein weiterer Körperschallwandler ist, wird durch das akustische Referenzsignal die Bedienplatte in Schwingung versetzt und schwingt dann mit einem haptisch wahrnehmenden Schwingsignal. Dies ist eine niederfrequente akustische Welle. Diese akustische Welle bringt die Schwingspule des Körperschallwandlers in Schwingung, sodass am Körperschallwandler eine der Schwingungsamplitude proportionale Spannung gemessen werden kann. Durch Berühren beziehungsweise einem zusätzlichen Ausüben eines individuellen Drucks und somit einer Druckstärke auf die Bedienplatte wird die durch das akustische Referenzsignal angeregte haptisch wahrnehmbare Schwingung beziehungsweise das akustische Schwingsignal der Bedienplatte erzeugt und somit auch die erzeugte akustische Welle gedämpft. Diese Dämpfung der akustischen Welle ist abhängig von dieser Druckstärke. Aus der Dämpfung der akustischen Welle resultiert eine niedrigere Spannung an den elektrischen Anschlüssen des Körperschallwandlers. Diese Spannungsänderung am Körperschallwandler ist ein Maß für die Druckstärke auf die Bedienplatte. Mit sehr sensitiven Körperschallwandlern lassen sich auch mehrere verschiedene Druckstärken ohne zusätzliche elektronische Messsignalaufbereitung, wie beispielsweise eine Verstärkung, auswerten. Werden in dem Zusammenhang weniger sensitive Körperschallwandler eingesetzt, kann das Signal am Körperschallwandler mit einem zusätzlichen Verstärker angepasst werden.

Es kann auch vorgesehen sein, dass dieser Körperschallwandler, der zur Erfassung des Ist-Schwingsignals vorgesehen ist, direkt an der Bedienplatte angeordnet ist. Insbesondere kann er direkt an einer Rückseite beziehungsweise Unterseite der Bedienplatte angeordnet sein. Dieser Körperschallwandler ist vorzugsweise an dieser Rückseite beziehungsweise Unterseite angeklebt. Er kann jedoch auch zusätzlich oder anstatt dazu an einer Platine der Bedienvorrichtung, insbesondere der Druckstärkenauswerteeinheit, angeordnet sein.

In einer weiteren Ausführung kann der Sensor zur Erfassung des Ist-Schwingsignals auch ein Körperschallmikrofon sein. Bei einer derartigen Ausgestaltung erfolgt das Auswerten der Druckstärke nach dem piezo- oder nach dem elektrodynamischen Prinzip. Ein Körperschallmikrofon kann örtlich vorzugsweise an den gleichen Positionen angeordnet sein, wie dies oben für einen Beschleunigungssensor oder einen genannten weiteren Körperschallsensor der Fall sein kann. Insbesondere ist ein Körperschallmikrofon empfindlicher als ein Beschleunigungssensor oder ein Körperschallwandler. Damit ist mit einem Körperschallmikrofon eine noch feinere Auflösung der Betätigung und somit der Druckstärke möglich. In einer vorteilhaften Ausführung ist vorgesehen, dass der Körperschallwandler zum Erzeugen des akustischen Rückmeldesignals und zum Erzeugen des akustischen Referenzsignals, und der Sensor zum Erfassen des Ist-Schwingsignals an gegenüberliegenden Bereichen eines berührsensitiven Bereichs des Bedienfelds und unmittelbar benachbart zum berührsensitiven Bereich angeordnet sind. Damit ist einerseits eine entsprechende räumliche Trennung geschaffen, die die individuellen Funktionalitäten und Aufgaben verbessert erfüllen lässt, andererseits durch die unmittelbare Nähe zum berührsensitiven Bereich auch die jeweilige Funktionalität bestmöglich durchführbar.

Vorzugsweise ist vorgesehen, dass ein erster Körperschallwandler und ein erster Sensor an einem ersten Bereich benachbart zum berührsensitiven Bereich des Bedienfelds angeordnet sind, und ein zweiter Körperschallwandler und ein zweiter Sensor an dem gegenüberliegenden zweiten Bereich benachbart zum berührsensitiven Bereich des Bedienfelds angeordnet sind. Bei einer derartigen, jeweils zumindest zweifachen Auslegung von Körperschallwandlern und Sensoren zum Erfassen des Ist-Signals kann die Flexibilität der Erfassung und Auswertung erhöht werden. Es ist insbesondere dann auch möglich, die Körperschallwandler einmal als Sender zum Aussenden des akustischen Rückmeldesignals und des akustischen Referenzsignals, und in einer anderen Messsituation als vorzugsweise ausgebildeter Empfänger zu nutzen. So ist es beispielsweise möglich, dass während eines Betriebs der Bedienvorrichtung die Anordnung umgeschaltet wird und in dem Zusammenhang die Funktionalität insbesondere der Körperschallwandler umgeschaltet wird. Dies kann insbesondere abhängig davon erfolgen, an welcher Stelle die Bedienplatte berührt wurde und eine individuelle Druckstärke ausgeübt wurde. Dadurch ist eine noch genauere und feinere Auflösung der Druckstärke bei Betätigung möglich, ohne dass zusätzliche weitere Messsensoren erforderlich sind. Insbesondere kann dieses Umschalten individuell automatisch durch eine Steuereinheit der Bedienvorrichtung erfolgen. Insbesondere kann dies abhängig davon erfolgen, auf welchem lokalen Bereich der Bedienplatte ein Berühren durch den Erfassungssensor erkannt wurde. Beispielsweise kann dies dahingehend erfolgen, dass bei einem gegenüberliegenden Positionieren von zwei Körperschallwandlern und somit einem dazwischenliegenden Positionieren des berührsensitiven Bereichs der linksseitige Körperschallwandler als Messsensor und somit als Empfänger zum Bestimmen einer Dämpfung betrieben wird, wenn das Berühren in einem Flächenhalbfeld der Bedienplatte erfolgt, die diesem Sensor zugewandt ist beziehungsweise diesem näher liegt. Der dann andere Körperschallwandler kann als Sensor genutzt werden.

In einer vorteilhaften Ausführung ist vorgesehen, dass abhängig von der bestimmten Druckstärke das von dem Körperschallwandler zu erzeugende akustische Rückmeldesignal individuell erzeugbar ist und/oder veränderbar ist. Damit kann sehr exakt, schnell und bedarfsgerecht die zur Druckstärke korrespondierende haptische beziehungsweise taktile Rückmeldung auf die aktuelle individuelle Berührung mit spezifischer Druckstärke der Bedienplatte erzeugt werden und an die Bedienplatte abgegeben werden beziehungsweise über diese mitgeteilt werden.

Auch bei beibehaltender Berührung der Bedienplatte und sich dann individuell auch dynamisch verändernder Druckstärke, um sehr schnell Änderungen von Betriebseinstellungen hervorrufen zu können, kann durch diese Ausgestaltung dann auch sehr schnell und sehr präzise das jeweils der Druckstärke zugehörige haptische Rückmeldesignal erzeugt werden.

In einer vorteilhaften Ausführung ist vorgesehen, dass abhängig von der bestimmten Druckstärke eine Anzeige auf dem Bedienfeld in der Darstellungsart veränderbar ist und/oder eine Geschwindigkeit der Änderung der Darstellung, insbesondere dem berührsensitiven Bereich, veränderbar ist und/oder die Menge der Darstellungen auf dem Bedienfeld veränderbar ist. Damit kann eine sehr vielfältige Informationspräsentation dynamisch und präzise geändert werden und auch individuell jeweils die zugehörige eindeutige haptische Rückmeldung gegeben werden. Vielfältige Anzeigevarianten sind dadurch ermöglicht und taktil rückmeldbar.

In einer vorteilhaften Ausführung ist vorgesehen, dass zumindest zwei diskrete unterschiedliche Druckstärken mit der Druckstärkenauswerteeinheit bestimmbar sind. Vorzugsweise sind mehr als zwei derartige diskrete Druckstärken mit der Druckstärkenauswerteeinheit erfassbar beziehungsweise bestimmbar.

Durch eine derartige Bedienvorrichtung wird auch die Möglichkeit geboten, fehlerhafte beziehungsweise auch versehentliche Betätigungen zu minimieren beziehungsweise eindeutig zu erkennen und auch auszuschließen. Fehlerhafte oder unbeabsichtigte Berührungen, beispielsweise durch auftreffende Wassertropfen auf die Bedienplatte oder dergleichen, die grundsätzlich eine entsprechende Erkennung einer Berührung nach sich ziehen, bei denen aber gemäß dem genannten Aspekt der Erfindung keine definierte Dämpfung beziehungsweise grundsätzlich gar keine Dämpfung auftritt und messbar ist, kann daraus geschlossen werden, dass eine unbeabsichtigte Berührung erfolgte. Eine definierte Dämpfung ist insbesondere nur dann gegeben, wenn eine Berührung mit einer Druckstärke größer einem minimalen Druckstärkenschwellwert erfolgt ist. Insbesondere kann in dem Zusammenhang über vorgegebene und insbesondere auch abgespeicherte Schwellwerte eine noch höhere Sicherheit im Hinblick auf die zuverlässige und richtige Berührungserkennung mit individueller Druckstärke ermöglicht werden.

Es kann in dem Zusammenhang auch eine sehr robuste und dennoch hochfunktionelle und bezüglich der Detektionswahrscheinlichkeit sehr genaue Bedienvorrichtung geschaffen werden. Insbesondere dann, wenn eine Bedienplatte üblicherweise als starre Platte, wie es beispielsweise bei einer Glasplatte oder einer Glaskeramikplatte der Fall ist, ausgebildet ist, kann dennoch eine nunmehr hinreichende Auswertung einer Druckstärke auf Basis der Dämpfung einer akustischen Welle bzw. Schwingung erfolgen. In vorteilhafter Weise kann mit der Bedienvorrichtung nicht nur ein örtlich lokales Drücken auf die Bedienplatte erfasst werden, sondern auch eine sogenannte Slider-Betätigung erfasst werden. Unter einer derartigen wird eine dynamische Bewegung einer Berührung mit einem entsprechenden Mittel, wie einem Finger, erfasst. Ein Finger wird in dem Zusammenhang im aufgesetzten Zustand auf die Bedienplatte relativ zu der Bedienplatte darauf bewegt und auch hier kann eine individuelle Druckstärke über den gesamten Betätigungsweg erfasst werden, als auch eine in dem Zusammenhang auf dem Betätigungsweg variierende Druckstärke erfasst werden. Damit ist auch eine druckstärkenabhängige Inhaltsanpassung der Anzeige auf dem Bedienfeld ermöglicht. Insbesondere ist somit auch eine, wie bereits oben erläutert, druckstärkenabhängige individuelle Erzeugung einer haptischen Rückmeldung ermöglicht. Dies kann sowohl im Hinblick auf die Amplitude als auch auf die Signalform erfolgen. Somit kann beispielsweise die Stärke eines in der Frequenz gleichbleibenden haptischen Rückmeldesignals verändert werden und/oder die Frequenz des haptischen Rückmeldesignals verändert werden, um die zugehörige beziehungsweise korrespondierende individuelle Druckstärke taktil zu vermitteln.

Ein weiterer Aspekt der Erfindung betrifft ein Haushaltsgerät mit einer Bedienvorrichtung gemäß dem oben genannten Aspekt oder einer vorteilhaften Ausgestaltung davon. Das Haushaltsgerät ist insbesondere zum Zubereiten von Lebensmitteln ausgebildet. Vorzugsweise kann das Haushaltsgerät ein Backofen oder ein Kochfeld sein. Grundsätzlich sind jedoch auch andere Haushaltsgeräte, beispielsweise zum Lagern und Konservieren von Lebensmitteln, wie beispielsweise einem Kühlgerät oder einem Gefriergerät oder einem Kühl-Gefrier-Kombigerät, möglich. Ebenso sind beispielsweise Haushaltsgeräte zur Pflege von Wäschestücken, wie beispielsweise eine Waschmaschine oder ein Wäschetrockner möglich. Auch ein Haushaltsgerät zum Reinigen von Geschirr, wie beispielsweise ein Geschirrspüler, kann mit einer derartigen Bedienvorrichtung ausgebildet sein.

Ein weiterer Aspekt der Erfindung betrifft ein Verfahren zum Betreiben einer Bedienvorrichtung für ein Haushaltsgerät. Bei dem Verfahren wird mit einem Erfassungssensor eines berührungssensitiven Bedienfelds der Bedienvorrichtung ein Berühren einer berührbaren Bedienplatte des Bedienfelds, die ebenfalls berührungssensitiv ist, erfasst. Abhängig von einem durch den Erfassungssensor erfassten Berühren der Bedienplatte wird mit einem Körperschallwandler der Bedienvorrichtung, der mit der Bedienplatte gekoppelt ist, ein akustisches Rückmeldesignal an die Bedienplatte erzeugt. Dieses akustische Rückmeldesignal kann insbesondere durch einen auf die Bedienplatte aufgelegten Finger von einem Nutzer wahrgenommen werden.

Mit einer Druckstärkenauswerteeinheit der Bedienvorrichtung wird eine beim Berühren der Bedienplatte erzeugte Druckstärke ausgewertet. Die Druckstärke wird abhängig von einer durch die Druckstärkenauswerteeinheit erfassten, und insbesondere durch das Drücken auf die Bedienplatte erzeugten Dämpfung eines durch den Körperschallwandler an die Bedienplatte abgegeben, akustischen Referenzsignals bestimmt. Dabei wird durch das akustische Referenzsignal ein dann bekanntes akustisches Schwingsignal der Bedienplatte erzeugt, wenn sie noch nicht berührt ist. Es wird durch die Druckstärkenauswerteeinheit das haptisch wahrnehmbare Schwingsignal der durch das akustische Referenzsignal zum Schwingen angeregten Bedienplatte ohne eine Berührung der Bedienplatte mit einem akustischen Ist-Schwingsignal an der Bedienplatte verglichen, und abhängig von dem Vergleich eine Dämpfung bestimmt. Dabei wird das Ist-Schwingsignal mit zumindest einem Sensor der Druckstärkenauswerteeinheit erfasst. Die diesbezüglich erreichbaren Vorteile wurden bereits oben zur Bedienvorrichtung erläutert.

Vorteilhafte Ausführungen der Bedienvorrichtung sind als vorteilhafte Ausführungen des Verfahrens anzusehen. Dabei können die individuellen Verfahrensschritte, die ein Erfassen und/oder Auswerten betreffen, durch die individuellen Komponenten der Bedienvorrichtung alleine und/oder in Wirkverbindung durchgeführt werden.

Der Erfassungssensor, mit dem ein grundsätzliches Berühren der Bedienplatte erfasst wird, kann ein resistiver Sensor oder ein kapazitiver Sensor oder ein Piezosensor oder ein Infrarotsensor sein. Sobald eine Betätigung des sensorischen beziehungsweise berührungssensitiven Bedienfelds erfolgt, wird in vorteilhafter Weise ein akustisches Rückmeldesignal als haptisches Signal durch den Körperschallwandler ausgelöst. In vorteilhafter Weise kann vorgesehen sein, dass die Anregung des Körperschallwandlers mit einer niedrigen Frequenz, beispielsweise zwischen 50 Hz und 250 Hz, insbesondere zwischen 50 Hz und 100 Hz, insbesondere zwischen 70 Hz und 95 Hz, erfolgt, um eine spürbare Schwingung der vorzugsweise sehr starren Bedienplatte aufzuprägen. Vorzugsweise hat ein Körperschallwandler eine Leistung kleiner oder gleich 3 Watt. Durch die niederfrequente akustische Anregung der Bedienplatte durch den Körperschallwandler bildet sich auf der Bedienplatte eine akustische Welle, insbesondere das genannte haptisch wahrnehmbare Schwingsignal aus, welches bei einer Berührung der Bedienplatte als haptisches Rückmeldesignal wahrgenommen werden kann. Diese sich ausbreitende niederfrequente akustische Welle in Form des haptisch wahrnehmbaren Schwingsignals wird abhängig von der Druckstärke auf die Bedienplatte unterschiedlich beeinflusst und somit unterschiedlich gedämpft. Diese Beeinflussung lässt sich mit der genannten Sensorik auswerten und kann als Maß für die Druckstärke zugrundegelegt werden.

Abhängig von der Druckstärke ändert sich insbesondere die Amplitude dieses haptisch wahrnehmbaren Schwingsignals an dem zur Erfassung dieser Änderung ausgebildeten Sensor, der dieses Ist-Signal erfasst. Umso stärker gedrückt wird, umso stärker erfolgt eine Dämpfung dieses haptisch wahrnehmbaren Schwingsignals. Ist nur ein akustisches Referenzsignal zugrundegelegt und nur ein davon abhängiges haptisch wahrnehmbares Schwingsignal einer Bedienplatte bekannt und abgespeichert, ist nur diese eine Größe als Bezugsgröße vorhanden, um die Dämpfung im Vergleich mit einem dann gemessenen akustischen Ist-Schwingsignal bestimmen zu können. Diese Signale können dann auch für ein gegebenenfalls vorhandenes weiteres Bedienfeld und/oder für eine weitere Bedienvorrichtung eines Haushaltsgeräts zugrundegelegt werden. Es kann bei einer derartigen Ausgestaltung vorteilhafterweise jedoch vorgesehen sein, dass für jedes Bedienfeld und somit für jede zugeordnete Bedienplatte ein abhängig von einem oder mehreren akustischen Referenzsignalen ausgebildetes haptisch wahrnehmbares Schwingsignal der individuellen Bedienplatte erzeugt und abgespeichert ist und somit individuelle Referenzen als Bezugsgrößen zugrundegelegt werden, die dann in einem Vergleich mit jeweils individuellen Ist-Signalen der individuellen Bedienplatten und individuellen Dämpfungsbestimmung zugrundegelegt werden und herangezogen werden. Insbesondere kann dies auch abhängig davon sein, welche Größe eine Bedienplatte aufweist. Bei größeren Bedienplatten kann es dann auch sinnvoll und vorteilhaft sein, mehrere Körperschallsensoren und/oder Sensoren zur Erfassung eines Ist-Signals anzuordnen.

Mit den Angaben "oben", "unten", "vorne", "hinten, "horizontal", "vertikal", "Tiefenrichtung", "Breitenrichtung", "Höhenrichtung" sind die bei bestimmungsgemäßen Gebrauch und bestimmungsgemäßen Anordnen der Vorrichtung bzw. des Geräts gegebenen Positionen und Orientierungen angegeben.

Weitere Merkmale der Erfindung ergeben sich aus den Ansprüchen, den Figuren und der Figurenbeschreibung.

Ausführungsbeispiele der Erfindung werden nachfolgend anhand schematischer Zeichnungen näher erläutert. Es zeigen:
- Fig. 1: eine perspektivische Darstellung eines Ausführungsbeispiels eines erfindungsgemäßen Haushaltsgeräts;
- Fig. 2: eine perspektivische Darstellung eines weiteren Ausführungsbeispiels eines erfindungsgemäßen Haushaltsgeräts;
- Fig. 3: eine vereinfachte schematische Darstellung eines Ausführungsbeispiels einer Bedienvorrichtung; und
- Fig. 4: eine entsprechende Darstellung wie in Fig. 3, jedoch für ein dazu unterschiedliches Ausführungsbeispiel einer Bedienvorrichtung.

In den Figuren werden gleiche oder funktionsgleiche Elemente mit den gleichen Bezugszeichen versehen.

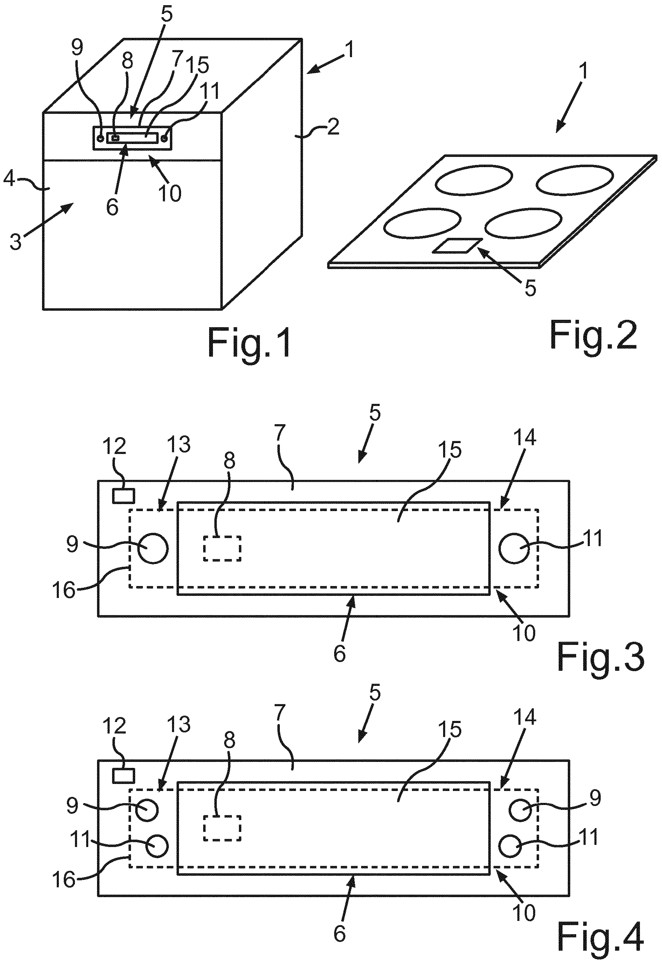

In Fig. 1 ist in einer schematischen Darstellung ein Ausführungsbeispiel eines Haushaltsgeräts 1 gezeigt, welches hier zum Zubereiten von Lebensmitteln ausgebildet ist. Das Haushaltsgerät 1 ist hier ein Backofen, kann jedoch auch ein Mikrowellengargerät oder ein Dampfgargerät sein, oder ein Gerät sein, welches zumindest zwei dieser Funktionalitäten zusätzlich aufweist.

Das Haushaltsgerät 1 weist ein Gehäuse 2 auf, in dem ein Garraum 3 ausgebildet ist. Der Garraum 3 ist durch eine Tür 4 verschließbar. Das Haushaltsgerät 1 weist darüber hinaus eine Bedienvorrichtung 5 auf. Diese ist weder örtlich noch bezüglich der Größe als abschließend zu verstehen anzusehen.

Die Bedienvorrichtung 5 weist zumindest ein berührungssensitives Bedienfeld 6 auf. Das Bedienfeld 6 weist eine berührbare und insbesondere auch berührungssensitive Bedienplatte 7 auf. Dieses Bedienfeld 6 weist darüber hinaus zumindest einen Erfassungssensor 8 auf, welcher zum Erfassen einer Berührung der Bedienplatte 7 ausgebildet ist. Darüber hinaus weist die Bedienvorrichtung 5 zumindest einen Körperschallwandler 9 auf, der ein zum Erfassungssensor 8 separater Wandler ist. Der Körperschallwandler 9 ist mit der Bedienplatte 7 gekoppelt. Der Körperschallwandler 9 ist zur Abgabe eines akustischen Rückmeldesignals an die Bedienplatte 7 abhängig von einem durch den Erfassungssensor 8 erfassten Berühren der Bedienplatte 7 ausgebildet. Darüber hinaus weist die Bedienvorrichtung 5 eine Druckstärkenauswerteeinheit 10 auf. Mit der Druckstärkenauswerteeinheit 10 ist eine beim Berühren der Bedienplatte 7 erzeugte Druckstärke auf die Bedienplatte auswertbar. Die Druckstärke ist abhängig von einer durch die Druckstärkenauswerteeinheit 10 erfassten und durch das Drücken auf die Bedienplatte 7 erzeugten Dämpfung eines durch den Körperschallwandler 9 an die Bedienplatte 7 abgegebenen akustischen Referenzsignals bestimmbar.

Die Druckstärkenauswerteeinheit 10 weist zumindest einen Sensor 11 auf, der ein zum Körperschallwandler 9 separater Sensor ist. Die Druckstärkenauswerteeinheit 10 ist zum Vergleichen eines haptisch wahrnehmbaren akustischen Schwingsignals der durch das akustische Referenzsignal zum Schwingen angeregten Bedienplatte 7 ohne eine Berührung der Bedienplatte 7 mit dem akustischen, und durch Berühren spezifisch gedämpften akustischen Ist-Schwingsignal an der Bedienplatte 7 ausgebildet und abhängig von dem Vergleich ist eine Dämpfung bestimmbar. Dies bedeutet, dass der Körperschallwandler 9 zum Erzeugen und Aussenden des akustischen Referenzsignals ausgebildet wird. Damit wird die Bedienplatte 7 in eine spezifische Schwingung versetzt beziehungsweise eine akustische Welle erzeugt. Diese entspricht dem haptisch wahrnehmbaren Schwingsignal der Bedienplatte 7, wenn diese nicht berührt ist. Dieses haptisch wahrnehmbare Schwingsignal ist bekannt und vorzugsweise in einer Speichereinheit 12 der Bedienvorrichtung 5 abgespeichert. Es ist der Bedienvorrichtung 5 durch diese Referenz also bekannt, wie die spezifische Bedienplatte 7 schwingt, wenn sie nicht berührt ist und durch das bekannte spezifische akustische Referenzsignal angeregt ist. Dieses bekannte haptisch wahrnehmbare Schwingungssignal kann somit als Bezugsgröße zum Vergleich mit einem aktuell dann jeweils gemessenen Ist-Schwingsignal herangezogen werden. Wird als beim Berühren der Bedienplatte 7 eine individuelle Druckstärke ausgeübt, die vorzugsweise größer einem vorgegebenen, minimalen Druckschwellwert ist, so kann grundsätzlich eine gewollte Bedienung und somit Berührung der Bedienplatte 7 erkannt werden und dann durch das Vergleichen des Ist-Signals mit dem abgespeicherten haptisch wahrnehmbaren Schwingsignal der Bedienplatte 7, dann aufgrund der Abweichung auf eine spezifische Druckstärke geschlossen werden. Durch die individuelle Druckstärke wird eine dazu korrespondierende individuelle Dämpfung dieses haptisch wahrnehmbaren Schwingsignals vollzogen, sodass durch die Abweichung des Ist-Signals von dem haptisch wahrnehmbaren Schwingsignal die Druckstärke bestimmt werden kann.

Der Sensor 11, der zur Erfassung des Ist-Signals ausgebildet und angeordnet ist, ist ein zum Körperschallwandler 9 separater Sensor. Dieser Sensor 11 kann beispielsweise jedoch auch ein individueller Körperschallsensor sein. Bei einer derartigen Ausgestaltung wird der Körperschallwandler dann als Messsensor beziehungsweise als Empfänger betrieben. Der Körperschallwandler 9 wird in einer spezifischen Ausführung jedoch als Sender betrieben. Es kann vorzugsweise vorgesehen sein, dass der Körperschallwandler 9 und der Sensor 11 an gegenüberliegenden Bereichen 13 und 14 und unmittelbar benachbart zu einem berührsensitiven Bereich 15, der an der von der Bedienplatte 7 bedeckt ist, angeordnet sind. Der Körperschallwandler 9 und der Bereich 15 sowie der Sensor 11 sind dann insbesondere in einer Reihe zueinander angeordnet, und alle Komponenten von der insbesondere zumindest bereichsweise zumindest semitransparent ausgebildeten Bedienplatte 7 abgedeckt.

Der Erfassungssensor 8 ist demgegenüber in vorteilhafter Weise bei einer frontseitigen Betrachtung der Bedienvorrichtung 5 hinter dem berührungssensitiven Bereich 15, der insbesondere einen Teilbereich der Bedienplatte 7 darstellt, angeordnet.

Der berührungssensitive Bereich 15 ist durch die demgegenüber größere Bedienplatte 7 abgedeckt. Wie zu erkennen ist, sind somit der Körperschallwandler 9 und der Sensor 11 vollständig außerhalb des Flächenbereichs des berührungssensitiven Bereichs 15 angeordnet, jedoch mit der Bedienplatte 7 gekoppelt. Vorzugsweise kann dazu vorgesehen sein, dass der Körperschallwandler 9 und/oder der Sensor 11 an einer in Betrachtungsrichtung abgewandten Hinterseite beziehungsweise Rückseite beziehungsweise Unterseite der Bedienplatte 7 angeordnet sind. Beispielsweise kann hier ein Ankleben vorgesehen sein. Zusätzlich oder anstatt dazu kann der Körperschallwandler 9 und/oder der Sensor 11 auf einer Platine 16 der Bedienvorrichtung 5 angeordnet sein. Der Sensor 11 kann alternativ zu einer genannten Ausführung als weiterer Körperschallwandler, der dann Signale empfängt und die Dämpfung misst beziehungsweise das gedämpfte haptisch wahrnehmbare Schwingsignal der Bedienplatte 7 misst, auch als einen Beschleunigungssensor oder ein Körperschallmikrofon ausgebildet sein.

In Fig. 2 ist in einer schematischen Darstellung ein weiteres Ausführungsbeispiel eines Haushaltsgeräts 1, welches insbesondere zum Zubereiten von Lebensmitteln ausgebildet ist, und welches hier als Kochfeld dargestellt ist, gezeigt. Die Ausgestaltung der Bedienvorrichtung 5 ist insbesondere entsprechend, wie sie zu Fig. 1 erläutert wurde.

In Fig. 3 ist in einer vergrößerten schematischen Darstellung die Bedienvorrichtung 5, wie sie zu Fig. 1 und Fig. 2 erläutert wurde, gezeigt. Es kann auch vorgesehen sein, dass der Körperschallwandler 9 in dem Bereich 14 angeordnet ist, und der Sensor 11 in dem Bereich 13 angeordnet ist.

In Fig. 4 ist in einer vereinfachten Darstellung entsprechend zu Fig. 3 ein weiteres Ausführungsbeispiel der Bedienvorrichtung 5 gezeigt. Im Unterschied zur Darstellung gemäß Fig. 3 ist hier vorgesehen, dass in beiden Bereichen jeweils ein Körperschallwandler 9 zum Aussenden von akustischen Rückmeldesignalen und akustischen Referenzsignalen als auch jeweils ein Sensor 11 vorhanden ist. Insbesondere bei dieser Ausführung kann durch die entsprechende redundante Auslegung bedarfsgerecht auch ein Umschalten der Funktionsweise eines Körperschallwandlers erfolgen, insbesondere wenn die Sensoren 11 auch als Körperschallwandler ausgebildet sind. Die Funktionsweise eines Senders und eines Empfängers kann dann individuell, insbesondere durch eine Steuereinheit der Bedienvorrichtung 5 eingestellt werden. Dies kann insbesondere abhängig davon erfolgen, in welchem lokalen Bereich eine Berührung der Bedienplatte 7, insbesondere im berührungssensitiven Bereich 15 erfolgt ist. In dem Zusammenhang ist zu erwähnen, dass die Anzahl und Position des Erfassungssensors 8 lediglich beispielhaft zu verstehen ist. Vorzugsweise ist die individuelle lokale Berührungsposition auf dem Bereich 15 durch einen Erfassungssensor 8 präzise bestimmbar. Dazu kann der Erfassungssensor 8 auch eine Mehrzahl von einzelnen Sensoren, insbesondere auch ein Sensorenarray, sein.

Abhängig von der detektierten Druckstärke kann dann durch den Körperschallwandler 9 in allen genannten Ausführungsbeispielen ein individuelles haptisches Rückmeldesignal erzeugt werden und/oder ein erzeugtes haptisches Rückmeldesignal individuell verändert werden. Bei der Darstellung in Fig. 4 ist somit ein erster Körperschallwandler 9 und ein erster Sensor 11 hier in dem ersten Bereich 13 und ein zweiter Körperschallwandler 9 und ein zweiter Sensor 11 in dem zweiten Bereich 14 angeordnet, insbesondere jeweils benachbart und bei frontseitiger Betrachtung überlappungsfrei mit dem berührungssensitiven Bereich 15 angeordnet. Auf dem berührungssensitiven Bereich 15 können individuelle Informationen optisch angezeigt werden, wobei abhängig von der Position der Berührung auf dem berührungssensitiven Bedienbereich 15 und/oder abhängig von der dann erzeugten Druckstärke und/oder abhängig von der Betätigungsart, wie beispielsweise einem nur lokalen punktuellen Berühren und/oder einem im berührten Zustand Entlangstreifen auf dem Bereich 15, eine individuelle Darstellungsart verändert werden und/oder eine Geschwindigkeit der Änderung der Darstellung verändert werden und/oder die Menge der Darstellungen auf dem Bedienfeld 6 verändert werden.

### Bezugszeichenliste

- 1: Haushaltsgerät
- 2: Gehäuse
- 3: Garraum
- 4: Tür
- 5: Bedienvorrichtung
- 6: Bedienfeld
- 7: Bedienplatte
- 8: Erfassungssensor
- 9: Körperschallwandler
- 10: Druckstärkenauswerteeinheit
- 11: Sensor
- 12: Speichereinheit
- 13: Bereich
- 14: Bereich
- 15: berührsensitiver Bereich
- 16: Platine

## Patentansprüche

1. Bedienvorrichtung (5) für ein Haushaltsgerät (1), mit einem berührsensitiven Bedienfeld (6), das eine berührbare Bedienplatte (7) und einen Erfassungssensor (8) zum Erfassen einer Berührung der Bedienplatte (7) aufweist, und mit einem Körperschallwandler (9), der mit der Bedienplatte (7) gekoppelt ist und zur Abgabe eines akustischen Rückmeldesignals an die Bedienplatte (7) abhängig von einem durch den Erfassungssensor (8) erfassten Berühren der Bedienplatte (7) ausgebildet ist, **dadurch gekennzeichnet, dass** die Bedienvorrichtung (5) eine Druckstärkenauswerteeinheit (10) aufweist, mit welcher eine bei Berühren der Bedienplatte (7) erzeugte Druckstärke auswertbar ist, wobei die Druckstärke abhängig von einer durch die Druckstärkenauswerteeinheit (10) erfassten Dämpfung eines durch den Körperschallwandler (9) an die Bedienplatte (7) abgegebenen akustischen Referenzsignals bestimmbar ist, wobei durch das akustische Referenzsignal ein dann bekanntes akustisches Schwingsignal der Bedienplatte (7) erzeugt ist, wenn sie noch nicht berührt ist, und die Druckstärkenauswerteeinheit (10) zum Vergleichen des haptisch wahrnehmbaren Schwingsignals der durch das akustische Referenzsignal zum Schwingen angeregten Bedienplatte (7) ohne eine Berührung der Bedienplatte (7) mit einem akustischen Ist-Schwingsignal an der Bedienplatte (7) ausgebildet ist und abhängig von dem Vergleich eine Dämpfung bestimmbar ist, und wobei die Druckstärkenauswerteeinheit (10) zumindest einen Sensor (11) zur Erfassung des Ist-Schwingsignals aufweist.

2. Bedienvorrichtung (5) nach Anspruch 1, **dadurch gekennzeichnet, dass** zumindest ein haptisches Schwingsignal in einer Speichereinheit (12) der Bedienvorrichtung (5) abgespeichert ist.

3. Bedienvorrichtung (5) nach einem der vorhergehenden Ansprüche, **dadurch gekennzeichnet, dass** der Sensor (11) ein Körperschallwandler ist.

4. Bedienvorrichtung (5) nach Anspruch 1 oder 2, **dadurch gekennzeichnet, dass** der Sensor (11) ein Beschleunigungssensor ist.

5. Bedienvorrichtung (5) nach Anspruch 1 oder 2, **dadurch gekennzeichnet, dass** der Sensor (11) ein Körperschallmikrofon ist.

6. Bedienvorrichtung (5) nach einem der vorhergehenden Ansprüche, **dadurch gekennzeichnet, dass** der Körperschallwandler (9) und der Sensor (11) an gegenüberliegenden Bereichen (13, 14) eines mit der Bedienplatte (7) abgedeckten, berührsensitiven Bereichs (15) des Bedienfels (6) und benachbart zum berührsensitiven Bereich (15) angeordnet sind.

7. Bedienvorrichtung (5) nach Anspruch 6, **dadurch gekennzeichnet, dass** ein erster Körperschallwandler (9) und ein erster Sensor (11) an einem ersten Bereich (13) benachbart zum berührsensitiven Bereich (15) angeordnet sind, und ein zweiter Körperschallwandler (9) und ein zweiter Sensor (11) an dem gegenüberliegenden zweiten Bereich (14) benachbart zum berührsensitiven Bereich (15) angeordnet sind.

8. Bedienvorrichtung (5) nach einem der vorhergehenden Ansprüche, **dadurch gekennzeichnet, dass** der Sensor (11) direkt an einer Unterseite der Bedienplatte (7) angeordnet ist und/oder an einer zur Bedienplatte (7) separaten Platine (16) angeordnet ist.

9. Bedienvorrichtung (5) nach einem der vorhergehenden Ansprüche, **dadurch gekennzeichnet, dass** abhängig von der bestimmten Druckstärke das von dem Körperschallwandler (9) zu erzeugende akustische Rückmeldesignal erzeugbar ist und/oder veränderbar ist.

10. Bedienvorrichtung (5) nach einem der vorhergehenden Ansprüche, **dadurch gekennzeichnet, dass** abhängig von der bestimmten Druckstärke eine Anzeige auf dem Bedienfeld (6) in der Darstellungsart veränderbar ist und/oder eine Geschwindigkeit der Änderung der Darstellung veränderbar ist und/oder die Menge der Darstellungen auf dem Bedienfeld (6) veränderbar ist.

11. Bedienvorrichtung (5) nach einem der vorhergehenden Ansprüche, **dadurch gekennzeichnet, dass** zumindest zwei diskrete und unterschiedliche Druckstärken mit der Druckstärkenauswerteeinheit (10) bestimmbar sind.

12. Haushaltsgerät (1), insbesondere zum Zubereiten von Lebensmitteln, mit einer Bedienvorrichtung (5) nach einem der vorhergehenden Ansprüche.

13. Verfahren zum Betreiben einer Bedienvorrichtung (5) für ein Haushaltsgerät (1), bei welchem mit einem Erfassungssensor (8) eines berührsensitiven Bedienfelds (6) der Bedienvorrichtung (5) ein Berühren einer berührbaren Bedienplatte (7) des Bedienfelds (6) erfasst wird, und abhängig von einem durch den Erfassungssensor (8) erfassten Berühren der Bedienplatte (7) mit einem Körperschallwandler (9) der Bedienvorrichtung (5), der mit der Bedienplatte (7) gekoppelt ist, ein akustisches Rückmeldesignal an die Bedienplatte (7) erzeugt wird, **dadurch gekennzeichnet, dass** mit einer Druckstärkenauswerteeinheit (10) der Bedienvorrichtung (5) eine bei Berühren der Bedienplatte (7) erzeugte Druckstärke ausgewertet wird, wobei die Druckstärke abhängig von einer durch die Druckstärkenauswerteeinheit (10) erfassten Dämpfung eines durch den Körperschallwandler (9) an die Bedienplatte (7) abgegebenen akustischen Referenzsignals bestimmt wird, wobei durch das akustische Referenzsignal ein dann bekanntes akustisches Schwingsignal der Bedienplatte (7) erzeugt ist, wenn sie noch nicht berührt ist, und durch die Druckstärkenauswerteeinheit (10) das haptisch wahrnehmbare Schwingsignal der durch das akustische Referenzsignal zum Schwingen angeregten Bedienplatte (7) ohne eine Berührung der Bedienplatte (7) mit einem akustischen Ist-Schwingsignal an der Bedienplatte (7) verglichen wird, und abhängig von dem Vergleich eine Dämpfung bestimmt wird, wobei das Ist-Schwingsignal mit zumindest einem Sensor (11) der Druckstärkenauswerteeinheit (10) erfasst wird.

## Claims

1. Operating device (5) for a household appliance (1), with a touch-sensitive control panel (6) which has a touchable operating plate (7) and a detecting sensor (8) for detecting a touching of the operating plate (7), and with a structure-borne sound converter (9) which is coupled to the operating plate (7) and is designed to emit an acoustic feedback signal on the operating plate (7) depending on a touching of the operating plate (7) detected by the detecting sensor (8), **characterised in that** the operating device (5) has a pressure intensity evaluation unit (10), with which a pressure intensity generated by a touching of the operating plate (7) can be evaluated, wherein the pressure intensity can be determined depending on an attenuation of an acoustic reference signal emitted on the operating plate (7) by the structure-borne sound converter (9), which attenuation is detected by the pressure intensity evaluation unit (10), wherein a then known acoustic vibration signal of the operating plate (7) is generated by way of the acoustic reference signal if the operating plate has not yet been touched, and the pressure intensity evaluation unit (10) is designed to compare the haptically perceptible vibration signal of the operating plate (7), which is excited into vibration by way of the acoustic reference signal, with an acoustic actual vibration signal on the operating plate (7), without the operating plate (7) being touched, and depending on the comparison an attenuation can be determined, and wherein the pressure intensity evaluation unit (10) has at least one sensor (11) for detecting the actual vibration signal.

2. Operating device (5) according to claim 1, **characterised in that** at least one haptic vibration signal is stored in a memory unit (12) of the operating device (5).

3. Operating device (5) according to one of the preceding claims, **characterised in that** the sensor (11) is a structure-borne sound converter.

4. Operating device (5) according to claim 1 or 2, **characterised in that** the sensor (11) is an acceleration sensor.

5. Operating device (5) according to claim 1 or 2, **characterised in that** the sensor (11) is a contact microphone.

6. Operating device (5) according to one of the preceding claims, **characterised in that** the structure-borne sound converter (9) and the sensor (11) are arranged on opposite regions (13, 14) of a touch-sensitive region (15) of the operating face (6) which is covered by the operating plate (7) and are arranged adjacent to the touch-sensitive region (15).

7. Operating device (5) according to claim 6, **characterised in that** a first structure-borne sound converter (9) and a first sensor (11) are arranged on a first region (13) adjacent to the touch-sensitive region (15) and a second structure-borne sound converter (9) and a second sensor (11) are arranged on the opposite second region (14) adjacent to the touch-sensitive region (15).

8. Operating device (5) according to one of the preceding claims, **characterised in that** the sensor (11) is arranged directly on an underside of the operating plate (7) and/or is arranged on a circuit board (16) which is separate to the operating plate (7).

9. Operating device (5) according to one of the preceding claims, **characterised in that** the acoustic feedback signal to be generated by the structure-borne sound converter (9) depending on the pressure intensity determined can be generated and/or changed.

10. Operating device (5) according to one of the preceding claims, **characterised in that**, depending on the pressure intensity determined, a display on the control panel (6) can be changed in terms of its display mode and/or a speed of the change to the representation can be changed and/or the quantity of representations on the control panel (6) can be changed.

11. Operating device (5) according to one of the preceding claims, **characterised in that** at least two discrete and different pressure intensities can be determined by the pressure intensity evaluation unit (10).

12. Household appliance (1), in particular for preparing food, with an operating device (5) according to one of the preceding claims.

13. Method for operating an operating device (5) for a household appliance (1) in which a touching of a touchable operating plate (7) of the control panel (6) is detected by a detecting sensor (8) of a touch-sensitive control panel (6) of the operating device (5) and depending on a touching of the operating plate (7) with a structure-borne sound converter (9) of the operating device (5) detected by the detecting sensor (8), which structure-borne sound converter is coupled to the operating plate (7), an acoustic feedback signal is generated on the operating plate (7), **characterised in that** a pressure intensity generated by a touching of the operating plate (7) is evaluated by a pressure intensity evaluation unit (10) of the operating device (5), wherein the pressure intensity is determined depending on an attenuation of an acoustic reference signal emitted by the structure-borne sound converter (9) on the operating plate (7), which attenuation is detected by the pressure intensity evaluation unit (10), wherein a then known acoustic vibration signal of the operating plate (7) is generated by way of the acoustic reference signal if the operating plate has not yet been touched, and the haptically perceptible vibration signal of the operating plate (7), which is excited into vibration by way of the acoustic reference signal, is compared with an acoustic actual vibration signal on the operating plate (7) by the pressure intensity evaluation unit (10), without the operating plate (7) being touched, and depending on the comparison an attenuation is determined, wherein the actual vibration signal is detected by at least one sensor (11) of the pressure intensity evaluation unit (10).

## Revendications

1. Dispositif de commande (5) pour un appareil ménager (1), avec un panneau de commande tactile (6), lequel présente une plaque de commande effleurable (7) et un capteur de détection (8) pour la détection d'un effleurement de la plaque de commande (7), et avec un transducteur de bruits de structure (9) couplé à la plaque de commande (7) et formé pour l'émission d'un signal de retour acoustique à destination de la plaque de commande (7) en fonction d'un effleurement de la plaque de commande (7) détecté par le capteur de détection (8), **caractérisé en ce que** le dispositif de commande (5) présente une unité d'évaluation de la puissance de pression (10) qui permet d'évaluer une puissance de pression générée lors d'un effleurement de la plaque de commande (7), dans lequel la puissance de pression peut être déterminée en fonction de l'atténuation détectée par l'unité d'évaluation de la puissance de pression (10) d'un signal de référence acoustique émis par le transducteur de bruits de structure (9) à destination de la plaque de commande (7), dans lequel un signal d'oscillation acoustique de la plaque de commande (7) alors connu est généré par le biais du signal de référence acoustique, lorsqu'elle n'est pas encore effleurée, et l'unité d'évaluation de la puissance de pression (10) est formée pour la comparaison du signal d'oscillation perceptible haptiquement de la plaque de commande (7) stimulée à osciller par le signal de référence acoustique sans effleurement de la plaque de commande (7) avec un signal d'oscillation acoustique effectif au niveau de la plaque de commande (7) et une atténuation peut être déterminée en fonction de la comparaison, et dans lequel l'unité d'évaluation de la puissance de pression (10) présente au moins un capteur (11) pour la détection du signal d'oscillation effectif.

2. Dispositif de commande (5) selon la revendication 1, **caractérisé en ce qu'**au moins un signal d'oscillation haptique est enregistré dans une unité de mémoire (12) du dispositif de commande (5).

3. Dispositif de commande (5) selon l'une des revendications précédentes, **caractérisé en ce que** le capteur (11) est un transducteur de bruits de structure.

4. Dispositif de commande (5) selon la revendication 1 ou 2, **caractérisé en ce que** le capteur (11) est un capteur d'accélération.

5. Dispositif de commande (5) selon la revendication 1 ou 2, **caractérisé en ce que** le capteur (11) est un microphone à bruits de structure.

6. Dispositif de commande (5) selon l'une des revendications précédentes, **caractérisé en ce que** le transducteur de bruits de structure (9) et le capteur (11) sont disposés dans des zones opposées (13, 14) d'une zone tactile (15) du panneau de commande (6) couverte par la plaque de commande (7) et dans le voisinage de la zone tactile (15).

7. Dispositif de commande (5) selon la revendication 6, **caractérisé en ce qu'**un premier transducteur de bruits de structure (9) et un premier capteur (11) sont disposés dans une première zone (13) dans le voisinage de la zone tactile (15) et un deuxième transducteur de bruits de structure (9) et un deuxième capteur (11) sont disposés dans la deuxième zone opposée (14) dans le voisinage de la zone tactile (15).

8. Dispositif de commande (5) selon l'une des revendications précédentes, **caractérisé en ce que** le capteur (11) est disposé directement sur un côté inférieur de la plaque de commande (7) et/ou sur une platine (16) séparée de la plaque de commande (7).

9. Dispositif de commande (5) selon l'une des revendications précédentes, **caractérisé en ce que** le signal de retour acoustique à générer par le transducteur de bruits de structure (9) peut être généré et/ou modifié en fonction de la puissance de pression déterminée.

10. Dispositif de commande (5) selon l'une des revendications précédentes, **caractérisé en ce qu'**en fonction de la puissance de pression déterminée, le mode de représentation d'un affichage sur le panneau de commande (6) peut-être modifié et/ou une vitesse de modification de la représentation peut-être modifiée et/ou la quantité des représentations sur le panneau de commande (6) peut être modifiée.

11. Dispositif de commande (5) selon l'une des revendications précédentes, **caractérisé en ce qu'**au moins deux puissances de pression discrètes et différentes peuvent être déterminées avec l'unité d'évaluation de la puissance de pression (10).

12. Appareil ménager (1), en particulier pour la préparation de denrées alimentaires, avec un dispositif de commande (5) selon l'une des revendications précédentes.

13. Procédé d'exploitation d'un dispositif de commande (5) pour un appareil ménager (1), dans lequel un effleurement d'une plaque de commande effleurable (7) du panneau de commande (6) est détecté avec un capteur de détection (8) d'un panneau de commande tactile (6) du dispositif de commande (5) et en fonction d'un effleurement de la plaque de commande (7) détecté par le capteur de détection (8), un transducteur de bruits de structure (9) du dispositif de commande (5) couplé à la plaque de commande (7) génère un signal de retour acoustique à destination de la plaque de commande (7), **caractérisé en ce qu'**une puissance de pression générée lors d'un effleurement de la plaque de commande (7) est évaluée avec une unité d'évaluation de la puissance de pression (10) du dispositif de commande (5), dans lequel la puissance de pression est déterminée en fonction de l'atténuation détectée par l'unité d'évaluation de la puissance de pression (10) d'un signal de référence acoustique émis par le transducteur de bruits de structure (9) à destination de la plaque de commande (7), dans lequel un signal d'oscillation acoustique de la plaque de commande (7) alors connu est généré par le biais du signal de référence acoustique, lorsqu'elle n'est pas encore effleurée, et l'unité d'évaluation de la puissance de pression (10) compare le signal d'oscillation perceptible haptiquement de la plaque de commande (7) stimulée à osciller par le signal de référence acoustique sans effleurement de la plaque de commande (7) avec un signal d'oscillation acoustique effectif au niveau de la plaque de commande (7) et une atténuation est déterminée en fonction de la comparaison, dans lequel le signal d'oscillation effectif est détecté avec au moins un capteur (11) de l'unité d'évaluation de la puissance de pression (10) .
